# EUROPEAN PATENT APPLICATION

(11) **EP 4 797 322 A1**
(43) Date of publication of application: **26.08.2026**
(21) Application number: 25158943.8
(22) Date of filing: 19.02.2025
(51) Int. Cl.: H01L 21/67

(54) **APPARATUS AND METHOD FOR CLEANING A CARRIER FOR SEMICONDUCTOR FABRICATION ARTICLES**

(71) Applicant: Brooks Automation (Germany) GmbH, 78256 Steißlingen (DE)
(72) Inventor: Grayfer, Anatoly, Sharon, MA, 02067 (US)
(74) Representative: Dehns Germany Partnerschaft mbB

(57) **Abstract**

The invention provides a cleaning apparatus (100) for cleaning a carrier (200) for semiconductor fabrication articles, particularly wafers, wherein the apparatus (100) comprises a degassing chamber (110) configured to accommodate at least one carrier (110), a heat source (120) provided within the degassing chamber (110), a protective frame (130) arranged at least partially around the heat source (120), such that the heat source (120) is prevented from physically contacting a carrier (200) placed into the degassing chamber (110), an evacuator (160), configured to withdraw gas from the degassing chamber (110) and to provide and/or maintain a vacuum pressure, which is lower than a predefined pressure threshold, within the degassing chamber (110), and a purge gas supply (140) configured to provide a purge gas (503) into the protective frame (130). Further, a method (500) for cleaning a carrier (200), particularly by operating such an apparatus (100), is provided.

## Description

The present invention relates to a method for cleaning a carrier (e.g. a FOUP) for semiconductor fabrication articles (for example wafers) and a corresponding cleaning apparatus.

### Background

Semiconductor carrier devices such as FOUPs (Front Opening Unified Pods) are important in connection with wafer transport and contamination control within and outside of semiconductor fabrication plants, also known as fabs. The environment within the FOUP, the FOUP mini-environment, is responsible for isolating the wafers from the fab environment and at the same time transporting the wafers safely between tools and within the fab. Since the wafers are constantly exposed to a variety of processes and chemicals, the same chemicals are released from the wafers via outgassing processes. As a result, the FOUP walls absorb this gaseous material on the surface and in pores of the FOUP walls, on the inside as well as the outside of the FOUP. A deep cleaning of the FOUP(s) now becomes essential as contamination would adversely impact other wafers, for example such wafers which are subsequently transported or stored in such a FOUP, due to the emission (e.g. desorption) of these substances from the FOUP.

In this disclosure, new approaches are suggested to deal with this problem and/or to achieve enhanced cleaning results over the prior art.

The same approaches could be used for cleaning other semiconductor carrier devices, such as, reticle pods, especially EUV pods.

### Summary

The present invention relates to a method for cleaning a carrier (for example, a FOUP) for semiconductor fabrication articles (for example wafers) and a corresponding cleaning apparatus as set out in the respective independent claims. Embodiments and additional features are provided in the dependent claims and further discussed in the following description.

The invention specifically pertains to using a hot gas to warm up the carrier prior to applying a vacuum to outgas the carrier in order to aid desorption of adsorbed (contaminant) species.

Carriers, such as FOUPs (front opening unified pods), are typically made of materials, for example polycarbonate materials, which provide a surface and/or pores, that contamination molecules, especially in the form of so called airborne molecular contamination AMC, may adhere to (e.g. by adsorption processes) and it requires energy in order for them to be able to diffuse away from the surface or out of the pores, respectively. Providing a hot purge gas, for example clean dry air CDA, as a first cleaning step, also referred to as hot purging, can effectively supply the required energy to enable molecules to desorb from the carrier material. The molecules thus diffused off the carrier material can then, with a second cleaning step, comprising applying a vacuum to the carrier, be effectively removed. This may improve the cleanliness level achieved by such cleaning over methods without such hot purging. A higher cleanliness of the carriers typically results in higher cleanliness of the articles stored or transported within the carrier and thus in better quality and/or higher yield of semiconductors produced using the articles.

In detail, according to a first aspect of the present invention, a cleaning apparatus comprises a degassing chamber configured to accommodate at least one carrier (particularly a FOUP), a heat source provided within the degassing chamber, a protective frame arranged at least partially around the heat source, such that the heat source is prevented from physically contacting a carrier placed into the degassing chamber, and a purge gas supply configured to provide, or in other words, transport a purge gas into the degassing chamber through the protective frame. Therefore, the purge gas is introduced via the protective frame which surrounds the heat source, thereby providing a very efficient way of heating the purge gas to the desired temperature. This allows rapid heating of the purge gas, and, in consequence, also of the carrier material, thereby reducing process time as compared to prior art cleaning devices and increasing overall throughput. The apparatus further comprises an evacuator, configured to withdraw gas from the degassing chamber and to provide and/or maintain a vacuum pressure, which is lower than a predefined pressure threshold, within the degassing chamber. Low pressure further aids desorption of contaminants from the surface of the carrier, such that it is especially beneficial to apply a vacuum (or sub-atmospheric pressure) to the carrier after applying a hot purge gas, such that the two effects (low pressure and elevated temperature) can simultaneously enhance the cleaning efficiency.

According to at least one embodiment, the heat source comprises at least one irradiator configured to emit electromagnetic radiation in the infrared spectral region. Radiative heating can provide some uniformity in heat distribution and also rapid transfer of energy such that this configuration provides fast transfer of energy for desorption of contaminants from the carrier, which is additionally aided with hot purge gas as well.

According to at least one embodiment, the protective frame comprises at least one hollow element configured to accept therein the purge gas from the purge gas supply, to transfer heat from the heat source to the purge gas and to release the purge as toward the at least one carrier within the degassing chamber. This accelerates the heat transfer to the purge gas and aids controlling the final temperature of the hot purge gas, since the heat transfer to the purge gas depends on the time the purge gas spends inside the hollow element, i.e. on the flow rate of the purge gas through the hollow element. The flow rate can be precisely controlled, for example, by a valve providing the purge gas to the protective frame. Alternatively, the protective frame may be provided in the form of a cage made of solid elements or bars, for example, and the purge gas may be introduced into an inner volume of the cage, i.e. to the direct surrounding of the heat source, which also provides for efficient heating of the purge gas.

Particularly, the at least one hollow element may comprise a metal pipe. This is a cost-efficient and mechanically stable solution, which furthermore is typically very efficient in terms of radiative heat absorption and conductive heat transfer (thermal conduction).

According to at least one embodiment, said at least one hollow element comprises at least one opening for releasing the purge gas from within the hollow element toward the at least one carrier. This provides a possibility to precisely direct the hot purge gas towards specific portions of the carrier, for example corners which are typically not purged very efficiently with a purely diffusion based approach. This way, purge efficiency can be improved, resulting in a higher level of cleanliness and thereby in a potentially higher yield in semiconductor products.

According to at least one embodiment, the degassing chamber comprises a body portion and a lid, wherein the lid is configured to sealingly engage with an opening in the body portion. This provides good access for the carrier to be placed into the degassing chamber or to be retrieved from the degassing chamber, while also allowing a low pressure to be reached and/or maintained within the degassing chamber.

Particularly, the lid may be configured to hold the at least one carrier in a predefined cleaning position. In other words, the carrier may be arranged on the lid before the degassing chamber is closed with the lid. This facilitates access to the degassing chamber because the carrier does not need to be arranged inside a cavity, but can be placed on a (substantially flat) lid, thus not requiring sophisticated handling means for placing the carrier on the lid.

According to at least one embodiment, each of the at least one carrier comprises at least two components detachable from one another, wherein the degassing chamber is configured to accommodate the at least two components in a detached state. This facilitates purging as fewer corners, typically hard to purge efficiently, are present in the carrier in the detached state.

Particularly, said predefined cleaning position may comprise a respective holder for each of said at least two components. This enables a repeatable arrangement of the at least components and thereby also a repeatable purging efficiency or performance.

Particularly, the at least two components may comprise a first component with a cavity for holding the articles and a second component for closing the cavity, wherein the predetermined cleaning positions are arranged in such a way that the cavity at least partially houses the heat source and the second component is arranged between the first component and the (optional) evacuator. This aids efficient heating and hot purging of the walls of the cavity as well as efficient heating and hot purging of the second component as the hot purge gas is guided in the direction of the second component on its way out of the degassing chamber via the evacuator.

According to at least one embodiment, the protective frame is further configured to mechanically support the heat source. As already described above, the protective frame is mechanically stable such that this stability can also be utilized for supporting the heat source. This also provides for a well-defined relative placement of the heat source and the protective frame, respectively, thereby enabling a precise temperature control of the protective frame (and the purge gas provided into the protective frame).

According to at least one embodiment, the apparatus further comprises at least one load port configured to transfer the at least one container from outside the apparatus to an inner volume of the apparatus, particularly wherein the at least one load port is configured as an airlock to prevent an atmosphere outside the apparatus from entering the inner volume. Alternatively or additionally, the load port may be configured to provide a warm purge gas to the carrier. This prevents contamination of the degassing chamber and thus ensures a high cleanliness level of the carrier after completed purging.

According to at least one embodiment, the apparatus may further comprise a washing chamber configured to apply a washing fluid and/or a drying gas to the carrier. The washing chamber may be provided as a unit separate from the degassing chamber or may be identical with the degassing chamber. In other words, the apparatus may comprise a single chamber used as the washing chamber and the degassing chamber (for example, in consecutive operation steps, respectively), or may comprise two chambers, of which one is the washing chamber and the other one is the degassing chamber. This offers an option for more thorough cleaning within the same apparatus.

According to a second aspect of the present invention, a method of cleaning a carrier for semiconductor fabrication articles comprises providing at least one carrier in a degassing chamber, providing a hot purge gas to the degassing chamber, after providing the hot purge gas, evacuating the degassing chamber, and after evacuating the degassing chamber, venting the degassing chamber by providing a purge gas, particularly at approximately room temperature or at an elevated temperature, to the degassing chamber. The method, in essence, provides similar advantages as the corresponding apparatus, which is essentially configured to perform such a method. Particularly, the method provides a rapid and efficient way of cleaning a carrier and thereby provides a high level of cleanliness and thus a high yield of semiconductor products produced using the articles stored and/or transported within the carrier.

According to at least one embodiment, providing a hot purge gas to the degassing chamber comprises activating a heat source within the degassing chamber, guiding a selected purge gas (e.g. CDA or N2) through at least one hollow element of a selected shape and diameter provided in the vicinity of the heat source, and releasing the purge gas from within the at least one hollow element into the degassing chamber. Thus, the purge gas is heated directly inside the degassing chamber, which is very energy efficient and safe. Furthermore, as already described in relation to the apparatus above, this allows a very uniform and rapid heating of the carrier, thus enabling a high purging quality.

According to at least one embodiment, providing the at least one carrier in a degassing chamber comprises detaching at least two components of the carrier from one another, wherein the method, after venting the degassing chamber, further comprises attaching the at least two components to one another to re-form the at least one carrier. This may improve the purging quality as less corners hindering purge gas flow in the vicinity of the carrier are present when the components are detached from one another.

Particularly, after re-forming the at least one carrier, the method may further comprise purging, at a load port, the at least one carrier with a warm purge gas. In such a case, the method may additionally comprise heating a purge gas utilizing a heat exchange, particularly against spent hot purge gas from within the degassing chamber, to provide the warm purge gas to the load port.

According to at least one embodiment, said warm purge gas at the load port has a temperature of at most 60°C.

According to at least one embodiment, the hot purge gas provided to the degassing chamber has a temperature sufficient to quickly heat up the carrier, up to a safe temperature level, which will not adversely affect the structural integrity of the carrier (for example, up to 100 °C). Particularly, when hollow elements of the protective frame are used to provide the purge gas to the degassing chamber, the shape of the hollow elements may allow to introduce purge gas as hot as ~200 °C or more with a flow rate of 100-300 Ipm, for example. Even at such high purge gas temperatures, this does not necessarily result in an excessively high surface temperature of the carrier. Particularly, depending on the flow rate, the temperature of the purge gas and a duration of the purge gas supply, the surface temperature of the carrier may be controlled.

According to at least one embodiment, the method further comprises controlling a heating power of said heat source depending on a surface temperature of the carrier and/or on an exhaust temperature of the purge gas.

### Brief description of the appended drawings

Figure 1 schematically depicts an embodiment of a cleaning apparatus according to the present invention in a first state of operation.
Figure 2 schematically depicts the cleaning apparatus of Fig. 1 in a second state of operation.
Figure 3 schematically illustrates an embodiment of a method of cleaning a carrier for semiconductor articles according to the present invention.
Figure 4 shows a diagram of a surface temperature development over time when performing an embodiment of a method according to the invention as compared to a method not forming part of the invention.

### Detailed description

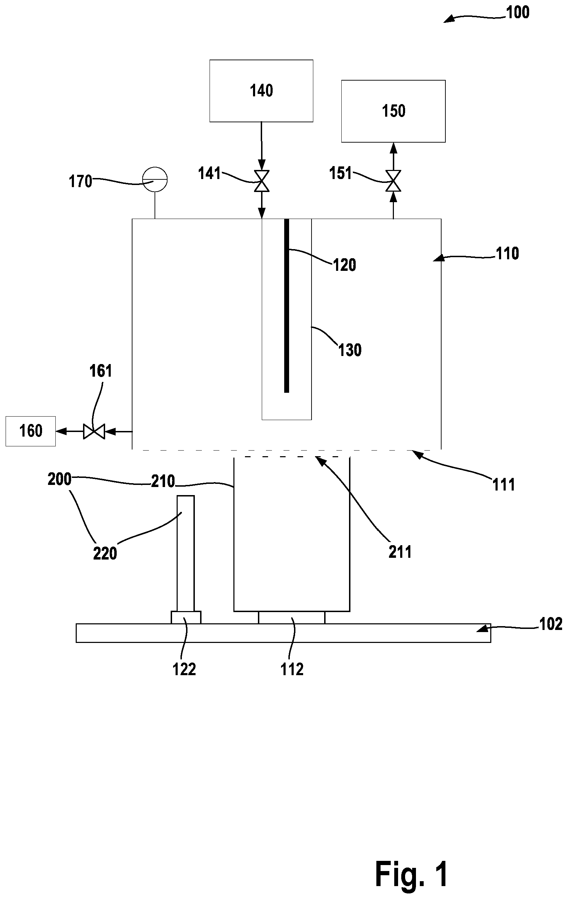

In Figure 1 an embodiment of a cleaning apparatus according to the present invention is schematically depicted and collectively referred to with reference numeral 100. The apparatus 100 comprises a degassing chamber 110, which has an opening 111 that is closable with a lid 102. Particularly, the lid 102 can be attachable to the degassing chamber 110 via an interface in the form of a flange substantially surrounding the opening 111. The degassing chamber 110 is configured to accommodate a carrier 200 for semiconductor articles such as semiconductor material wafers. The degassing chamber 110 is connected via respective valves 141, 151, 161 to a purge gas supply 140, a metrology unit 150 and an evacuator 160, respectively.

The purge gas supply 140 is configured to supply a purge gas, for example so-called clean dry air (CDA), extremely clean dry air (xCDA), nitrogen, argon or any other suitable purge gas, to the degassing chamber 110, wherein the valve 141 may be configured as a metering valve for controlling a flow rate of the purge gas into the degassing chamber 110 and/or as a shutoff valve that can be controlled to allow purge gas to flow into the degassing chamber 110 or to block a flow path of the purge gas into the degassing chamber 110 completely.

The metrology unit 150 may comprise one or more sensors that are configured to identify at least one constituent of a gas present within the degassing chamber 110 and/or to determine a concentration or a relative amount of one or more such constituents. Particularly, the metrology unit 150 may be configured to determine a relative humidity of the gas present in the degassing chamber 110 and/or presence and/or concentration of at least one chemical species selected from the common groups of Airborne Contaminants, particularly Molecular Bases (MB), Molecular Acids (MA), Molecular Condensable (MC) and Molecular Dopants (MD) It possible to extend this capability to measure a broader range of (volatile) organic compounds (VOCs) and also airborne particulates (not necessarily only solid particulates but also airborne aerosols).

Particularly, the organic compounds may comprise substituted and/or unsubstituted hydrocarbons (e.g. represented by the generic formula CₘHₙXₒ, in which Cₘ stands for a number of carbon atoms, Hₙ stands for a number of hydrogen atoms and Xₒ stands for a number of atoms other than carbon or hydrogen, in each case per molecule). Typically, organic compounds relevant in the context of embodiments of this invention comprise volatile, i.e. at least partially evaporable, substances, under conditions present in the apparatuses or during performing the methods discussed herein. Such volatile organic compounds may also be referred to as so-called airborne molecular contaminants (AMC).

Particularly relevant particulates in the context of embodiments of this invention are particles that may be at least partially suspended and/or carried in a gas stream. Examples for such particles may include particles of one or more materials comprised in the carrier 200, the degassing chamber 110 or any article storable or transportable in the carrier 200. Typically, such particles may be generated during normal use of the carrier and/or the degassing chamber or during handling and/or processing of the article. Relevant particle sizes may include particle sizes smaller than 10 nm or even smaller than 1 nm. In this context, it is not particularly relevant by which measurement technique such particle sizes are determined. However, it is noted that the particle sizes discussed herein may be regarded as determined by any microscopy method such as scanning electron microscopy (SEM) or transmission electron microscopy (TEM), for example. This does not mean that the metrology unit 150 needs to include such a microscope or any microscopic device.

As mentioned, the metrology unit 150 is connected to the degassing chamber 110 via a valve 151 such that a flow of a sample gas from the degassing chamber 110 into the metrology unit 150 may be allowed and/or blocked and/or controlled as desired or required.

The evacuator 160 is configured to withdraw a gas from the degassing chamber 110. Particularly, the evacuator 160 may comprise a vacuum pump, particularly a (single stage) oil-free vacuum pump, that is capable of providing and/or maintaining a pressure below a predetermined pressure threshold (for example, the pressure threshold may be below 1 kPa, particularly below 0.1 kPa, such as in the range of 10 Pa to 20 Pa, e.g. 15 Pa) within the degassing chamber 110. The pressure inside the degassing chamber 110 may be monitored using a sensor 170, for example. This sensor 170 may alternatively or additionally be configured to monitor other conditions, such as temperature, inside the degassing chamber 110. The evacuator 160, in the example shown, is connected to the degassing chamber 110 via valve 161 that can be actuated to allow and/or control and/or block a gas flow from the degassing chamber 110 to the evacuator 160. The pressure inside the degassing chamber may be adjusted, for example, by adequately controlling the valve 161.

Particularly, the carrier 200 may comprise a FOUP (front opening unified pod) that comprises a first component 210 with a cavity for accepting the articles and a second component 220 for closing an opening 211 of the cavity. The first component 210 and the second component 220 are reversibly attachable to one another, i.e. the second component 220 can be detached from the first component 210 such that it is movable completely independently from the first component 210 when detached. On the other hand, when the two components 210, 220 are attached to one another, it may still be possible to move the two components 210, 220 relative to one another, for example when the attachment forms a hinge. However, the movement of the two components 210, 220 is not independent from one another, when they are attached to one another.

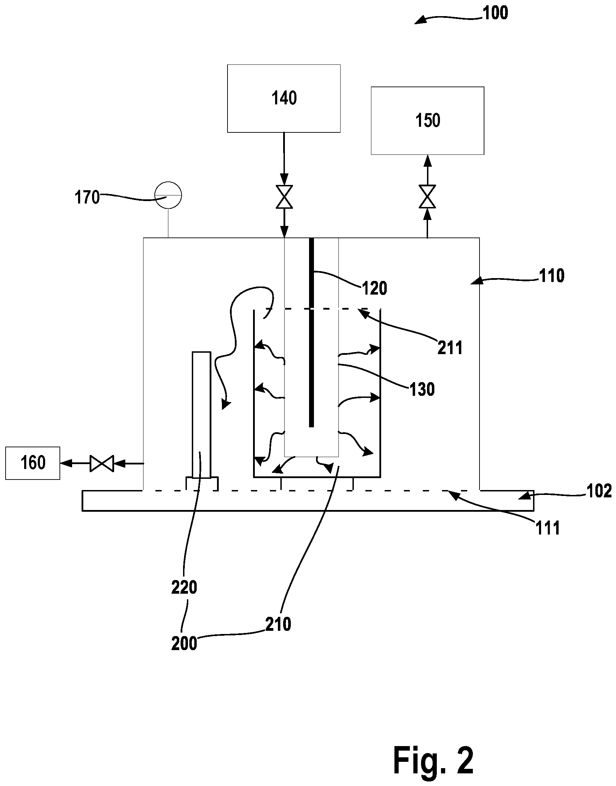

In Figures 1 and 2 the two components 210, 220 are shown in a detached state, i.e. separated from one another. Particularly, the first component 210 is arranged on a first support member 112 provided in or on the lid 102, whereas the second component 220 of carrier 200 is arranged on a second support member 122 provided in or on the lid 102. Particularly, the opening 211 of the cavity in the first component 210 faces away from the first support member 112 and towards the opening 111 of the degassing chamber 110. In Figure 1, the degassing chamber 110 is shown in an open state, i.e. the lid 102 is removed from the opening 111, whereas in Figure 2, the degassing chamber 110 is shown in a closed state, i.e. the lid 102 is in sealing engagement with the opening 111.

In the degassing chamber, a heat source 120 and a protective frame 130 arranged around the heat source 120 are provided, specifically extending into the degassing chamber 110 from a side opposite the opening 111. In the example shown, the protective frame 130 comprises hollow elements, for example pipes, through which the purge gas provided by the purge gas supply 140 is guided. The heat source 120 may particularly be provided in the form of an IR-radiation source, for example an IR-lamp, with a thermal power in the range of 0.5 kW to 5 kW, particularly in the range of 1 kW to 3 kW, such as around 2 kW. When the heat source 120 is activated, the protective frame 130 may at least partially absorb heat and thereby also heat the purge gas guided through the hollow elements. For example, when the heat source 120 is controlled to output about 2 kW of thermal power, the hollow elements of protective frame 130 may be heated to a temperature of about 280 °C to 330 °C, at least in some areas. The hollow elements comprise openings for releasing the purge gas from the protective frame 130 into the degassing chamber 110. For example, small holes may be provided in walls of the hollow elements, such that the purge gas may be released through these small holes. Particularly, the openings in the hollow elements may be directed away from the heat source 120, i.e. towards a location in which inner walls of the first component 220 of the carrier 200 are positioned, when the apparatus 100 is used for cleaning the carrier 200, i.e. in the closed position as shown in Fig. 2.

When the lid 102 is in the closed state, the carrier 200 is situated inside the degassing chamber 110 and particularly, the first component 210 is located such that the heat source 120 and the protective frame 130 are at least partially extending into the cavity of the carrier 200. The second component 220 of the carrier 200, in the example shown here, is arranged next to the first component 210 in a position, which is closer to the evacuator 160 (or a terminal of a conduit for gas from the degassing chamber 110 to the evacuator 160) than the position, in which the first component 210 of the carrier 200 is placed. This results in purge gas provided to the degassing chamber 110 through the protective frame 130 being drawn towards the second component 220 before leaving the degassing chamber 110. In other words, by arranging the second component 220 between the first component 210 (into which the purge gas is initially released) and the exit of the degassing chamber 110, the purge gas is likely to also impinge upon the second component 220, thereby transporting heat from the heat source 120 towards the second component 220 and thus improving desorption of potential contaminants from the surface (and pores) of the second component 220. Exemplary flow paths of the purge gas from the protective frame 130 towards the inner walls of the first component 210 of carrier 200 and towards the second component 220 are schematically illustrated in Fig. 2 as curved arrows. This use of a hot purge gas improves the heating efficiency as compared to methods without such a dedicated hot purge strategy.

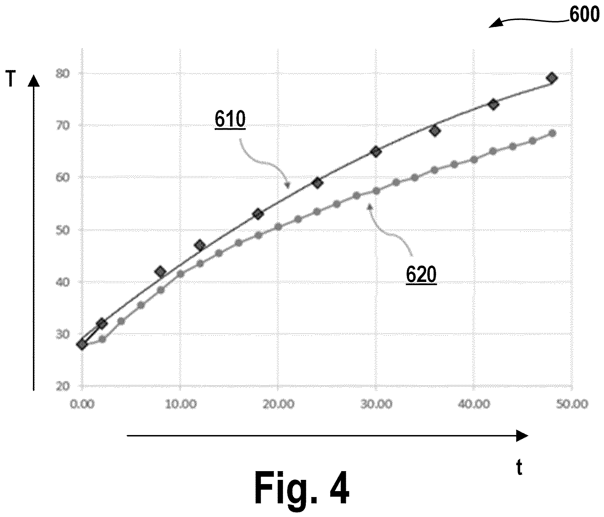

Figure 4 shows this difference in the form of a diagram, generally designated 600, of a surface temperature (T in degrees Celsius) development over time (t in seconds) when performing a hot purge as described herein (using an exemplary flow rate of 100 L/min and an IR-radiation power of the heat source 120 of 2 kW; curve 610) compared to a strategy without simultaneous hot purge, i.e. only activating the heat source 120 with an IR-radiation power of 2 kW without simultaneously providing purge gas to the protective frame 130 (purge gas flow rate is 0 L/min; curve 620). As can be seen from diagram 600, the time t required for reaching a certain target surface temperature T on the inner wall surface of the first component 210 (e.g. 65 °C) is substantially reduced by using the hot purge strategy (curve 610). For example, heating time can be reduced by about 30% to 40% as compared to the same heating power without hot purging (curve 620).

Apart from the faster heating of the carrier 200, it is also observed that the heat distribution is more uniform when the hot purging described herein is applied to the carrier as compared to a conventional heating strategy using only heat source 120 without simultaneously providing a purge gas via protective frame 130.

Before and/or after this hot purging, the evacuator 160 may be used to decrease pressure inside the degassing chamber 110 in order to remove previously adsorbed species. During such an evacuation, the heat source 120 may be deactivated or controlled to output lower thermal power as compared to the hot purging operation phase, in order to prevent overheating the carrier 200. The whole operation inside the degassing chamber may be monitored by the sensor 170 and/or the metrology unit 150. This monitoring may be performed continuously or at intervals, such that the hot purging may be repeated (for example with intermittent evacuations) or continued until a desired level of cleanliness and/or a desired target condition (e.g. target temperature and/or pressure of the gas inside the degassing chamber 110) is reached, for example.

This hot purge significantly improves heating uniformity and heating rate (by 30-40%) and therefore improves overall degassing efficiency of the carrier as compared to conventional cleaning methods without application of a hot purge gas. For example, a test was carried out using a EBM type FOUP typically utilized by advanced semiconductor fabs, which had previously been intentionally exposed to an atmosphere containing 1000 ppb of ammonia (model contaminant) for 24 hours. As an example, if 10 ppb is considered an acceptable contamination level threshold, then application of the high-power IR source (2 kW) and the hot purge as described herein (e.g. CDA stream at 100 L/min) increases the time, the FOUP retains an acceptable cleanliness (i.e. the time until the concentration of ammonia inside the FOUP reaches 10 ppb) by a factor of ~6-7 as compared to a conventional method with 0.5 kW IR irradiation and without hot purge.

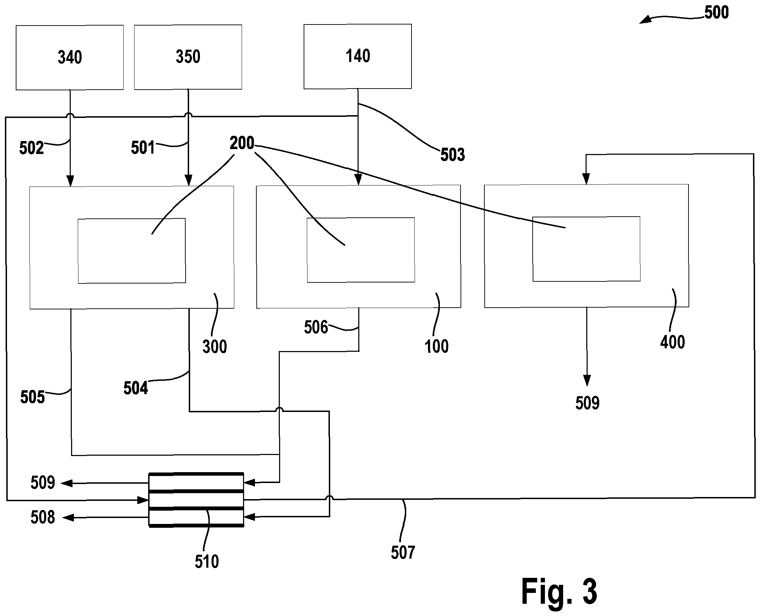

In Figure 3, an embodiment of a method of cleaning a carrier 200 for semiconductor articles according to the present invention is schematically illustrated and collectively referred to with reference 500. The method 500 is depicted in the form of functions performed by system components and the reference numerals used for the functions may also be regarded as references to the respective system components performing such functions. Particularly, reference numerals 100 and 140 are identical with the ones used in connection with Fig. 1 and 2 and illustrate the functions provided by the apparatus 100 and the purge gas supply 140, respectively. Similarly, reference numeral 200 designates the carrier 200 as already shown in connection with Fig. 1 and 2, and illustrate that the functions shown in Fig. 3 are applied to the carrier 200, particularly in order to clean carrier 200.

Apart from the hot purge 100 of carrier 200, which has already been described in detail with reference to Fig. 1 and 3, the method 500 illustrated in Fig. 3 comprises a washing step 300, prior to the hot purge 100, and a final warm purge 400, subsequent to the hot purge 100.

The washing step 300 may particularly take place in a dedicated washing chamber, separate from the degassing chamber 110. However, it is also conceivable to provide a degassing chamber configured to provide the washing step 300 and the hot purging 100 therein. Independent of the specific arrangement, the washing step 300 initially utilizes a washing fluid 501, particularly an at least partially liquid washing fluid or a fluid aerosol, to remove contaminants from the surface and/or pores of carrier 200. For example, the washing fluid 501 may comprise one or more additives and/or substances selected from the group comprising water (particularly, ultra-pure water; UPW), and one or more detergent(s). The washing fluid 501 may be provided in the form of a jetted stream to the inside and/or outside of carrier 200, for example through nozzles.

After the washing fluid 501, the washing step 300 may utilize a drying gas 502 to remove residual washing fluid 501 from a surface of carrier 200. The drying gas 502 may comprise the same or different components as the purge gas (designated 503 in Fig. 3) described above and may be selected from the same group of gases, for example clean dry air (CDA), extremely clean dry air (xCDA), nitrogen, argon or any other suitable drying gas.

Particularly, the washing fluid 501 and/or the drying gas 502 may be provided to the washing step 300 at an elevated temperature by washing fluid and/or drying gas heaters 350, 340, respectively. For example, the elevated temperature of the washing fluid 501 and/or the drying gas 502 may be selected from the range of 50 °C to 100 °C, particularly between 60 °C and 80 °C. As described above, the purge gas 503 for the hot purge 100 is, however, provided at a lower temperature, such as room temperature (for example, at between 20 °C and 30 °C), and is only heated by the (hollow) protective frame 130 in degassing chamber 110.

During the washing step 300, it is preferred that the carrier 200 be disassembled as in the hot purge 100 in degassing chamber 110, described above, in order to provide unhindered access to the internal cavity of the carrier 200. Potentially, it might be conceivable to wash the carrier in an assembled state (for example in an open state in which the first and second components 210, 220 are pivoted away from one another about a hinge; not shown in the drawings). However, washing in the disassembled state also provides advantages in terms of cleanliness, as, for example, connection members for attaching the first and second components to one another may be washed in the disassembled state.

After the hot purge 100, however, the first and second components 210, 220 need to be reassembled to re-form the usable carrier 200. In the example shown in Fig. 3, after this reassembly, which is not specifically depicted, a last warm purge 400 is performed. It is particularly foreseen, that this warm purge 400 takes place in or at a load port, which is generally configured to transfer the carrier 200 from an exterior of apparatus 100 to an interior volume of apparatus 100. Particularly, the load port used in connection with the warm purge 400 may be configured as an airlock to prevent an atmosphere surrounding apparatus 100 from entering therein and/or the inner volume of carrier 200. A purge gas 507 used for the warm purge 400 may be the same as the one used as the drying gas 502 or the purge gas 503 used for the hot purge 100. Particularly, the warm purge gas 507 may be heated to its use temperature (e.g. around 50 °C to 60 °C) by a heat exchange 510 against one or more exhaust or waste fluids 504, 505, 506, effluent from the washing step 300 and/or the hot purge 100, respectively. That way, waste heat from those purposes may be integrated into a process step requiring less heat, thereby decreasing the overall energy demand of the method 500 and increasing efficiency. Furthermore, the heat exchange reduces the temperature of final waste streams 509 (gaseous waste) and 508 (liquid waste), respectively, which facilitates treatment of those waste streams 508, 509. Any known kind of heat exchanger may be utilized for the heat exchange 510. Preferably, inert, non-contaminating materials such as stainless steel may be used in the heat exchanger, to ensure proper quality of the purge gas provided to the carrier 200.

Depending on the specific setup of an apparatus performing method 500, the method steps 300 (washing step), 100 (hot purge) and 400 (warm purge) may be performed sequentially with respect to a single one carrier 200, or may be performed at least partially simultaneously or at the same time with respect to several different carriers. For example, if a dedicated washing chamber for performing the washing step 300, a dedicated degassing chamber 110 for the hot purge 100 and one or more load ports for performing the warm purge 400 are provided separately, one carrier 200 may be washed 300, while another carrier 200 is hot purged 100 at the same time, for example.

It should be noted that the functions of the method 500 may all be included in devices forming the apparatus 100, although this is not specifically shown in the drawings for reasons of intelligibility.

Alternatively or additionally, some of the functions of method 500 may be performed by separate apparatuses, such that, for example a specific apparatus is provided for the washing step 300, while an additional apparatus 100 is provided separately for the hot purge 100. Typically, the warm purge 400 will, however, be performed in a load port attached to the apparatus 100 in order to exclude contamination of the cavity of carrier 200, as explained above.

## Claims

1. Cleaning apparatus (100) for cleaning a carrier (200) for semiconductor fabrication articles, particularly wafers, wherein the apparatus (100) comprises
a degassing chamber (110) configured to accommodate at least one carrier (110),
a heat source (120) provided within the degassing chamber (110),
a protective frame (130) arranged at least partially around the heat source (120), such that the heat source (120) is prevented from physically contacting a carrier (200) placed into the degassing chamber (110),
an evacuator (160), configured to withdraw gas from the degassing chamber (110) and to provide and/or maintain a vacuum pressure, which is lower than a predefined pressure threshold, within the degassing chamber (110), and
a purge gas supply (140) configured to provide a purge gas (503) into the degassing chamber through the protective frame (130).

2. Apparatus according to claim 1, wherein the heat source (120) comprises at least one irradiator configured to emit electromagnetic radiation in the infrared spectral region.

3. Apparatus (100) according to any one of the preceding claims, wherein the protective frame (130) comprises at least one hollow element configured to accept therein the purge gas (503) from the purge gas supply (140), to transfer heat from the heat source (120) to the purge gas (503) and to release the purge gas towards the at least one carrier (200) within the degassing chamber (110), particularly wherein the at least one hollow element comprises a metal pipe, and/or wherein the at least one hollow element comprises at least one opening for releasing the purge gas (503) from within the hollow element toward the at least one carrier (200).

4. Apparatus (100) according to any one of the preceding claims, wherein the degassing chamber (110) comprises a body portion and a lid (102), wherein the lid (102) is configured to sealingly engage with an opening (111) in the body portion.

5. Apparatus (100) according to claim 4, wherein the lid (102) is configured to hold the at least one carrier (200) in a predefined cleaning position.

6. Apparatus (100) according to any one of the preceding claims, wherein each of the at least one carrier (200) comprises at least two components (210, 220) detachable from one another, and wherein the degassing chamber (110) is configured to accommodate the at least two components (210, 220) in a detached state, particularly wherein, in combination with at least claim 5, the predefined cleaning position comprises a respective holder (112, 122) for each of the at least two components (210, 220), and/or
wherein the at least two components (210, 220) comprise a first component (210) with a cavity for holding the articles and a second component (220) for closing the cavity, wherein the predetermined cleaning positions are arranged in such a way that the cavity at least partially houses the heat source (120) and the second component (220) is arranged between the first component (210) and the evacuator (160).

7. Apparatus (100) according to any one of the preceding claims, wherein the protective frame (130) is further configured to mechanically support the heat source (120).

8. Apparatus (100) according to any one of the preceding claims, further comprising at least one load port (400) configured to transfer the at least one container from outside the apparatus (100) to an inner volume of the apparatus (100), particularly wherein the at least one load port (400) is configured as an airlock to prevent an atmosphere outside the apparatus (100) from entering the inner volume and/or to provide a warm purge gas (507) to the carrier (200), and/or
further comprising a washing chamber (300) configured to apply a washing fluid (501) and/or a drying gas (502) to the at least one carrier (200), wherein the washing chamber (300) is separate from or identical with the degassing chamber (110).

9. Method (500) of cleaning a carrier (200) for semiconductor fabrication articles, particularly wafers, wherein the method (500) comprises providing at least one carrier (200) in a degassing chamber (110), providing (100) a hot purge gas (503) to the degassing chamber (110), after providing the hot purge gas (503), evacuating the degassing chamber (110), and
after evacuating the degassing chamber, venting the degassing chamber (110) by providing a purge gas (503) to the degassing chamber (110).

10. Method (500) according to claim 9, wherein providing a hot purge gas to the degassing chamber (110) comprises
activating a heat source (120) within the degassing chamber (110), guiding a purge gas (503) through at least one hollow element provided in the vicinity of the heat source (120), and
releasing the purge gas from within the at least one hollow element into the degassing chamber (110).

11. Method (500) according to claim 9 or 10, wherein providing the at least one carrier (200) in a degassing chamber (110) comprises detaching at least two components (210, 220) of the carrier (200) from one another, wherein the method (500), after venting the degassing chamber (110), further comprises attaching the at least two components (210, 220) to one another to re-form the at least one carrier (200).

12. Method (500) according to claim 11, after re-forming the at least one carrier (200) further comprising purging (400), at a load port, the at least one carrier (200) with a warm purge gas.

13. Method (500) according to claim 12, comprising heating a purge gas (503) utilizing a heat exchange (510), particularly against spent hot purge gas (506) from within the degassing chamber (110), to provide the warm purge gas (507) to the load port.

14. Method (500) according to claim 12 or 13, wherein the warm purge gas at the load port has a temperature of at most 60°C.

15. Method (500) according to any one of claims 10 to 14, further comprising controlling a heating power of the heat source (120) depending on a surface temperature of the carrier (200) and/or on an exhaust temperature (170) of the purge gas (506).
